# EUROPÄISCHE PATENTSCHRIFT

(11) **EP 2 245 274 B1**
(45) Veröffentlichungstag und Bekanntmachung des Hinweises auf die Patenterteilung: **25.07.2012**
(21) Anmeldenummer: 09710045.7
(22) Anmeldetag: 04.02.2009
(51) Int. Cl.: F01D 5/28, F01D 5/00, C23C 28/00, C23C 30/00, C23C 4/00, C23C 4/08, C23C 4/10

(54) **VORRICHTUNG UND VERFAHREN ZUR PARTIELLEN BESCHICHTUNG VON BAUTEILEN**
DEVICE AND METHOD FOR THE PARTIAL COATING OF COMPONENTS
PROCEDE ET DISPOSITIF DE REVETEMENT PARTIEL D'ELEMENTS

(30) Priorität: 14.02.2008 DE 102008011242
(43) Veröffentlichungstag der Anmeldung: 03.11.2010
(73) Patentinhaber: MTU Aero Engines GmbH, 80995 München (DE)
(72) Erfinder: EICHMANN, Wolfgang, 82178 Puchheim (DE); HEUTLING, Falko, 81377 München (DE); UIHLEIN, Thomas, 85221 Dachau (DE); LACHNER, Josef, 85305 Jetzendorf Kemmoden (DE)
(86) Internationale Anmeldenummer: PCT/DE2009/000153
(87) Internationale Veröffentlichungsnummer: WO 2009/100706

(56) Entgegenhaltungen:
- EP-A- 0 925 845
- EP-A- 1 143 032
- DE-C1- 4 425 991
- US-A- 5 792 267

## Beschreibung

Die vorliegende Erfindung betrifft eine Vorrichtung zur partiellen Beschichtung eines Bauteils, insbesondere zur Beschichtung von Bauteilen einer Gasturbine oder eines Flugtriebwerkes. Die Erfindung betrifft weiterhin ein Verfahren zur partiellen Beschichtung eines Bauteils, insbesondere zur Beschichtung von Bauteilen einer Gasturbine oder eines Flugtriebwerkes.

Bauteile, insbesondere Bauteile einer Gasturbine oder eines Flugtriebwerks, die einer Erosionsbelastung ausgesetzt sind, werden üblicherweise mit Schichten, insbesondere Erosionsschutzschichten überzogen. Diese Schutzschichten können jedoch einen negativen Einfluss auf die Schwingfestigkeit und/oder Lebensdauer derartiger Bauteile ausüben. Dies gilt insbesondere bei keramischen Hartstoffschichten, die insbesondere dem Erosionsschutz dienen, da die Gefahr besteht, dass Anrisse in der keramischen Schicht rasch in den Grundwerkstoff des Bauteils laufen und zu einem vorzeitigen Versagen des Bauteils führen. Insbesondere treten diese Anrisse in Schichtbereichen mit hoher Bauteilbeanspruchung, wie zum Beispiel mit hoher Dehnung auf. Die Möglichkeit der Bildung derartiger Anrisse in beschichteten Bauteilbereichen mit hoher Beanspruchung, insbesondere hoher mechanischer Beanspruchung wirkt sich daher negativ auf die Qualität und die Lebensdauer des entsprechenden Bauteils in diesem Bereich aus.

Es ist daher Aufgabe der vorliegenden Erfindung eine gattungsgemäße Vorrichtung zur partiellen Beschichtung eines Bauteils, insbesondere zur Beschichtung von Bauteilen einer Gasturbine oder eines Flugtriebwerkes bereitzustellen, die eine sichere und schnelle Beschichtung des Bauteils unter Berücksichtigung kritischer Bauteilbereiche, d.h. Bereiche mit hoher Bauteilbeanspruchung, insbesondere mechanischer Beanspruchung, ermöglicht. Es ist weiterhin Aufgabe der vorliegenden Erfindung ein gattungsgemäßes Verfahren zur partiellen Beschichtung eines Bauteils, insbesondere zur Beschichtung von Bauteilen einer Gasturbine oder eines Flugtriebwerkes bereitzustellen, welches eine sichere und schnelle Beschichtung des Bauteils unter Berücksichtigung kritischer Bauteilbereiche, d.h. Bereiche mit hoher Bauteilbeanspruchung, insbesondere mechanischer Beanspruchung, ermöglicht. Gelöst werden diese Aufgaben durch eine Vorrichtung gemäß den Merkmalen des Anspruchs 1 sowie ein Verfahren gemäß den Merkmalen des Anspruchs 13.

Vorteilhafte Ausgestaltungen der Erfindung sind in den jeweiligen Unteransprüchen beschrieben.

Eine erfindungsgemäße Vorrichtung zur partiellen Beschichtung eines Bauteils, insbesondere zur Beschichtung von Bauteilen einer Gasturbine oder eines Flugtriebwerks weist mindestens eine Grundaufnahme für die zumindest teilweise Aufnahme des Bauteils und eines ersten nicht zu beschichtenden Teilbereichs des Bauteils sowie mindestens eine in der Grundaufnahme positionierbare plattenartige Abdeckung auf, wobei die Abdeckung mindestens eine Ausnahme oder Öffnung zum Durchtritt eines zu beschichtenden zweiten Teilbereichs des Bauteils aufweist und die Form der Ausnahme oder Öffnung dem Profil des Bauteils in dem Bereich zwischen dem nicht zu beschichtenden und dem zu beschichtenden Teilbereich entspricht. Die erfindungsgemäße Vorrichtung ermöglicht es, dass kritische Bauteilbereiche, d. h. Bereiche mit hoher Bauteilbeanspruchung, insbesondere hoher mechanischer Beanspruchung maskiert bzw. abgedeckt werden können, so dass diese Bereiche nicht beschichtet werden. Dadurch wird in diesen kritischen Teilbereichen des Bauteils vermieden, dass Anrisse auf Grund einer Beschichtung in den Grundwerkstoff des Bauteils in diesem Bereich entstehen und insgesamt zu einem vorzeitigen Versagen des Bauteils führen. Die nicht abgedeckten bzw. maskierten Teilbereiche des Bauteils können sicher und schnell beschichtet werden. Bei der Ausgestaltung der plattenartigen Abdeckung und der entsprechenden Ausnahme oder Öffnung für den Durchtritt des zu beschichtenden Teilbereichs werden die Erkenntnisse über das Beanspruchungsmuster des Bauteils, insbesondere eines mechanischen Beanspruchungsmusters berücksichtigt, so dass eine optimierte Verteilung zwischen beschichteten und nicht beschichteten Teilbereichen des Bauteiles erfolgen kann.

In vorteilhaften Ausgestaltungen der erfindungsgemäßen Vorrichtung ist die Abdeckung eben, uneben oder gewölbt oder im Querschnitt gerade, gekrümmt oder polygonal ausgebildet. Auch andere Ausgestaltungen der Abdeckung sind denkbar, wobei der Ausgestaltung der Abdeckung immer eine optimierte Trennung zwischen zu beschichtenden und nicht zu beschichtenden Teilbereichen des Bauteils in Kenntnis der Bauteilbeanspruchung zugrunde gelegt wird. Des Weiteren ist es möglich, dass die Abdeckung aus Metall, einer Metall-Legierung, Keramik, Glas oder Kunststoff, insbesondere temperaturbeständigem Kunststoff besteht.

In einer weiteren vorteilhaften Ausgestaltung der erfindungsgemäßen Vorrichtung weist die Grundaufnahme zur Positionierung, insbesondere zur Höhenpositionierung der Abdeckung entsprechende Auflagebereiche oder Vorsprünge auf. Dadurch ist es möglich, die Grundaufnahme der im jeweiligen Einzelfall notwendigen Trennung von zu beschichtenden und nicht zu beschichtenden Teilbereichen des Bauteils anzupassen.

In einer weiteren vorteilhaften Ausgestaltung der erfindungsgemäßen Vorrichtung ist die Grundaufnahme verschiebbar zur Änderung der Position der Abdeckung gegenüber dem Bauteil ausgebildet. Dadurch ist es möglich, zum Beispiel während des Beschichtungsprozesses eine Positionsänderung der Abdeckung relativ zu dem beschichtenden Bauteil durchzuführen. Dadurch ist es vorteilhafterweise möglich, die Schichtdicke der Beschichtung zu variieren. Des Weiteren ist es möglich, insbesondere bei mehrlagigen Schichten unterschiedliche Schichtpakete auf dem Bauteil aufzutragen.

In einer weiteren vorteilhaften Ausgestaltung der erfindungsgemäßen Vorrichtung weist die Vorrichtung mindestens eine Fixiervorrichtung zur lösbaren Fixierung der Abdeckung an dem Grundkörper auf. Dabei kann die Fixiervorrichtung hülsenartig mit mindestens einer Durchtrittsöffnung zum Durchtritt des zu beschichtenden zweiten Teilbereichs des Bauteils ausgebildet sein.

In einer weiteren vorteilhaften Ausgestaltung der erfindungsgemäßen Vorrichtung erfolgt die partielle Beschichtung des Bauteils mittels eines physikalischen Dampfabscheideverfahrens (PVD).

In einer weiteren vorteilhaften Ausgestaltung der Erfindung ist die Beschichtung eine Schutzschicht, insbesondere eine Erosionsschutzschicht. Dabei kann die Schutzschicht insbesondere aus einem hartkeramischen Werkstoff und/oder einem Metall oder einer Metall-Legierung bestehen. Als hartkeramischer Werkstoff kann z. B. Titannitrid Verwendung finden. Die Schutzschicht kann dabei aus mehreren Lagen bestehen, wobei z. B. alternierend eine Lage aus einem hartkeramischen Werkstoff und einem Metall oder einer Metall-Legierung aufgebaut ist.

In weiteren vorteilhaften Ausgestaltungen der erfindungsgemäßen Vorrichtung ist das Bauteil eine Schaufel eines Rotors einer Gasturbine, wobei die Schaufel insbesondere Bestandteil einer integralen Rotor-Konstruktion (BLISK oder BLING) sein kann. Ein erfindungsgemäßes Verfahren zur partiellen Beschichtung eines Bauteils, insbesondere zur Beschichtung von Bauteilen einer Gasturbine oder eines Flugtriebwerks umfasst folgende Schritte:
a) Aufnahme und Positionieren des Bauteils in einer Grundaufnahme;
b) Abdecken eines nicht zu beschichtenden Teilbereichs des Bauteils mittels einer Abdeckung, wobei ein zu beschichtender Teilbereich des Bauteils durch eine Ausnahme oder Öffnung in der Abdeckung hindurchgeführt wird und die Form der Ausnahme oder Öffnung dem Profil des Bauteils in dem Bereich zwischen dem nicht zu beschichtenden und dem zu beschichtenden Teilbereich entspricht; und
c) Beschichten des zu beschichtenden Teilbereichs des Bauteils.

Durch das erfindungsgemäße Verfahren ist es vorteilhafterweise möglich, dass kritische Bauteilbereiche, d. h. Bereiche mit hoher Bauteilbeanspruchung, insbesondere mechanischer Beanspruchung maskiert bzw. abgedeckt werden, so dass es zu keiner Beschichtung in diesen Teilbereichen des Bauteils kommt. Damit wird eine durch die Beschichtung initiierte Rissbildung, die sich in den Bereich des Grundwerkstoffs des Bauteils erstrecken kann zuverlässig verhindert. Des Weiteren ist eine sichere und schnelle Beschichtung derjenigen Teilbereiche des Bauteils möglich, die außerhalb der genannten kritischen Bauteilbereiche liegen. Die Ausgestaltung der Abdeckung berücksichtigt dabei die Verteilung der Bauteilbeanspruchung, wobei die Teilbereiche mit hoher Bauteilbeanspruchung durch die Abdeckung zuverlässig maskiert werden. In einer vorteilhaften Ausgestaltung des erfindungsgemäßen Verfahrens erfolgt vor dem Verfahrensschritt c) eine Fixierung der Grundaufnahme mit der Abdeckung mittels einer Fixiervorrichtung. Des Weiteren ist es möglich, dass die Fixiervorrichtung hülsenartig mit mindestens einer Durchtrittsöffnung zum Durchtritt des zu beschichtenden zweiten Teilbereichs des Bauteils ausgebildet ist. Durch diese Verfahrensschritte ist eine sichere Positionierung der Abdeckung in der Grundaufnahme wie auch eine sichere Befestigung des zu beschichtenden Bauteils in der Grundaufnahme gewährleistet.

In einer weiteren vorteilhaften Ausgestaltung des erfindungsgemäßen Verfahrens ist die Grundaufnahme verschiebbar zur Änderung der Position der Abdeckung gegenüber dem Bauteil ausgebildet, wobei eine Änderung der Position der Abdeckung nach und/oder während der Beschichtung gemäß Verfahrensschritt c) erfolgt. Durch die Möglichkeit zur Änderung der Position der Abdeckung gegenüber dem Bauteil ist es möglich, dass unterschiedliche Schichtdicken auf das Bauteil aufgetragen werden. Des Weiteren ist es möglich, dass zum Beispiel bei mehrlagigen Beschichtungen die Schichtbereiche mit einer unterschiedlichen Schichtabfolge auf das Bauteil aufgetragen werden. Des Weiteren wird dadurch eine Beschichtung mit einem homogenen Schichtauslauf ermöglicht.

In einer weiteren vorteilhaften Ausgestaltung des erfindungsgemäßen Verfahrens erfolgt die partielle Beschichtung des Bauteils mittels eines physikalischen Dampfabscheideverfahrens (PVD).

In einer weiteren vorteilhaften Ausgestaltung des erfindungsgemäßen Verfahrens wird durch das Beschichten gemäß Verfahrensschritt c) eine Schutzschicht, insbesondere eine Erosionsschutzschicht ausgebildet. Die Schutzschicht kann dabei aus einem hartkeramischen Werkstoff, wie z. B. TiN und/oder einem Metall oder einer Metall-Legierung bestehen. Die Schutzschicht kann zudem mehrlagig ausgebildet sein, wobei z. B. hartkeramische Werkstoffe und metallische Werkstoffe alternierend ausgebildet sind.

Verwendung findet eine Vorrichtung oder ein Verfahren wie im Vorhergehenden beschrieben insbesondere bei der Herstellung und Reparatur von Triebwerksbauteilen, insbesondere zur Herstellung, Reparatur und Beschichtung von integralen Rotor-Konstruktionen (BLISK oder BLING).

Ein erfindungsgemäßes Bauteil einer Gasturbine oder eines Flugtriebwerkes wird nach einem im Vorstehenden beschriebenen erfindungsgemäßen Verfahren und/oder mittels einer im Vorstehenden beschriebenen erfindungsgemäßen Vorrichtung hergestellt. Dabei kann das Bauteil eine Schaufel eines Rotors einer Gasturbine oder eine Schaufel als Bestandteil einer integralen Rotor-Konstruktion (BLISK oder BLING) sein.
Weitere Vorteile, Merkmale und Einzelheiten der Erfindung ergeben sich aus der nachfolgenden Beschreibung zweier zeichnerisch dargestellter Ausführungsbeispiele. Dabei zeigen
- Fig. 1: eine schematische Darstellung eines partiell zu beschichtenden Bauteils;
- Fig. 2: eine schematische Darstellung einer erfindungsgemäßen Vorrichtung zur partiellen Beschichtung eines Bauteils gemäß einer ersten Ausführungsform; und
- Fig. 3: eine schematische Darstellung einer erfindungsgemäßen Vorrichtung gemäß einer zweiten Ausführungsform.

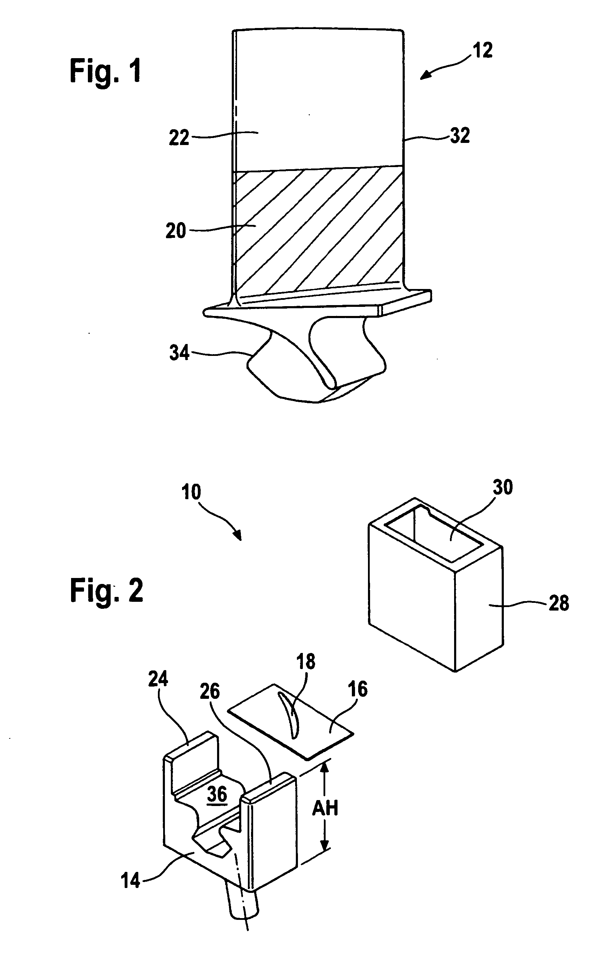

Fig. 1 zeigt eine schematische Darstellung eines partiell zu beschichtenden Bauteils 12. Bei dem Bauteil 12 handelt es sich um eine Schaufel eines Rotors einer Gasturbine bestehend aus einem Schaufelblatt 32 und einem Schaufelfuß 34. In der Fig. 1 sind zudem ein erster nicht zu beschichtender Teilbereich 20 und ein zweiter zu beschichtender Teilbereich 22 des Bauteils 12 bzw. der Schaufel schematisch dargestellt. Im Bereich der ersten Teilbereichs 20 treten besonders hohe mechanische Bauteilbeanspruchungen auf.
Fig. 2 zeigt eine schematische Darstellung einer Vorrichtung 10 zur partiellen Beschichtung des in Fig. 1 dargestellten Bauteils 12. Die Vorrichtung 10 umfasst dabei eine Grundaufnahme 14 für die teilweise Aufnahme des Bauteils 12, insbesondere des Schaufelfußes 34 des ersten Teilbereichs 20 des Schaufelblatts 32. Die Grundaufnahme 14 weist eine diesen Bereichen des Bauteils 12 in seiner Form angepasste Ausnehmung 36 auf. Des Weiteren weist die Vorrichtung 10 eine plattenartige Abdeckung 16 auf, wobei die Abdeckung 16 eine Öffnung 18 zum Durchtritt des zu beschichtenden zweiten Teilbereichs 22 des Bauteils 12 aufweist. Man erkennt, dass die Form der Öffnung 18 dem Profil des Bauteils 12 in dem Bereich zwischen dem nicht zu beschichtenden und dem zu beschichtenden Teilbereich 20, 22 (vergleiche auch Fig. 1) entspricht. In dem dargestellten Ausführungsbeispiel ist die Abdeckung 16 eben und im Querschnitt gerade ausgebildet. Es sind aber auch andere Ausgestaltungen der Abdeckung 16 entsprechend dem Verlauf des Grenzbereichs zwischen dem zu beschichtenden zweiten Teilbereich 22 und dem nicht zu beschichtenden ersten Teilbereich 20 möglich. Des Weiteren weist die Grundaufnahme 14 zur Positionierung und insbesondere zur Höhenpositionierung der Abdeckung 16 zwei gegenüberliegende Auflagebereiche 24, 26 auf. Die Auflagehöhe AH wird dabei durch die Anordnung der Auflagebereiche 24, 26 in oder an der Grundaufnahme 14 definiert. Die in dem Ausführungsbeispiel dargestellte Vorrichtung 10 weist zudem eine Fixiervorrichtung 28 zur lösbaren Fixierung der Abdeckung 16 an dem Grundkörper 12 auf. Dabei ist die Fixiervorrichtung 28 hülsenartig ausgebildet und wird über die Grundaufnahme 14 gestülpt. Für den Durchtritt des zu beschichtenden zweiten Teilbereichs 22 des Bauteils 12 weist die Fixiervorrichtung 28 eine Durchtrittsöffnung 30 auf.

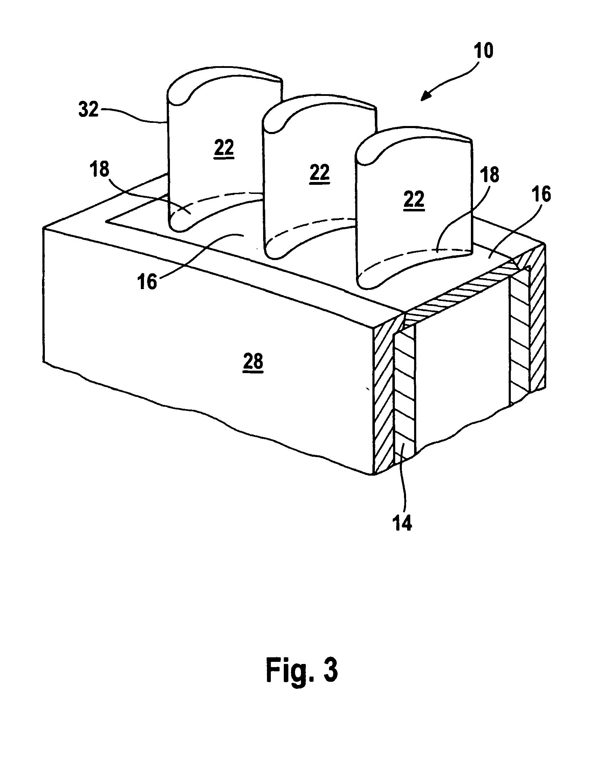

Fig. 3 zeigt eine schematische Darstellung einer Vorrichtung 10 gemäß einer zweiten Ausführungsform. Die Vorrichtung 10 ist dabei teilweise geschnitten dargestellt. Man erkennt, dass die Grundaufnahme 14 und die Abdeckung 16 von der hülsenartig ausgebildeten Fixiervorrichtung 28 umgeben sind. Die Abdeckung 16 weist in diesem Ausführungsbeispiel insgesamt drei Öffnungen 18 für den Durchtritt entsprechender zu beschichtender Teilbereiche 22 eines Bauteils 12 auf. Bei den Teilbereichen 22 handelt es sich wiederum um Teilbereiche von Schaufeln eines Rotors einer Gasturbine. Insbesondere handelt es sich um Teilbereiche der Schaufelblätter 32. Man erkennt, dass die Öffnungen 18 wiederum eine Form aufweisen, die dem Profil des Schaufelblatts 32 in dem Bereich zwischen dem nicht zu beschichtenden und dem zu beschichtenden Teilbereich 20, 22 entspricht.

## Patentansprüche

1. Vorrichtung zur partiellen Beschichtung von Bauteilen einer Gasturbine oder eines Flugtriebwerkes, wobei die Vorrichtung (10) mindestens eine Grundaufnahme (14) für die zumindest teilweise Aufnahme des Bauteils (12) und eines ersten nicht zu beschichtenden Teilbereichs (20) des Bauteils (12) sowie mindestens eine in der Grundaufnahme (14) positionierbare plattenartige Abdeckung (16) aufweist, wobei die Abdeckung (16) mindestens eine Ausnahme oder Öffnung (18) zum Durchtritt eines zu beschichtenden zweiten Teilbereichs (22) des Bauteils (12) aufweist, **dadurch gekennzeichnet, dass** die Form der Ausnahme oder Öffnung (18) dem Profil eines Schaufelblatts in dem Bereich zwischen dem nicht zu beschichtenden und dem zu beschichtenden Teilbereich (20, 22) entspricht, insbesondere unter Berücksichtigung eines definierten Spaltmaßes für einen homogenen Schichtauslauf.

2. Vorrichtung nach Anspruch 1, **dadurch gekennzeichnet, dass** die Abdeckung (16) ein oder mehrteilig, eben, uneben oder gewölbt oder im Querschnitt gerade, gekrümmt oder polygonal ausgebildet ist.

3. Vorrichtung nach Anspruch 1 oder 2, **dadurch gekennzeichnet, dass** die Abdeckung (16) aus Metall, einer Metall-Legierung, Keramik, Glas oder Kunststoff, insbesondere temperaturbeständigen Kunststoff besteht.

4. Vorrichtung nach einem der vorhergehenden Ansprüche, **dadurch gekennzeichnet, dass** die Grundaufnahme (14) zur Positionierung, insbesondere zur Höhenpositionierung der Abdeckung (16) entsprechende Auflagebereiche (24, 26) oder Vorsprünge aufweist.

5. Vorrichtung nach einem der vorhergehenden Ansprüche, **dadurch gekennzeichnet, dass** die Vorrichtung (10) mindestens eine Fixiervorrichtung (28) zur lösbaren Fixierung der Abdeckung (16) an dem Grundkörper (12) aufweist.

6. Vorrichtung nach Anspruch 5, **dadurch gekennzeichnet, dass** die Fixiervorrichtung (28) hülsenartig mit mindestens einer Durchtrittöffnung (30) zum Durchtritt des zu beschichtenden zweiten Teilbereichs (22) des Bauteils (12) ausgebildet ist.

7. Vorrichtung nach einem der vorhergehenden Ansprüche, **dadurch gekennzeichnet, dass** die Beschichtung eine Schutzschicht, insbesondere eine Erosionsschutzschicht ist.

8. Vorrichtung nach Anspruch 7, **dadurch gekennzeichnet, dass** die Schutzschicht aus einem hartkeramischen Werkstoff und/oder einem Metall oder einer Metall-Legierung besteht.

9. Vorrichtung nach einem der vorhergehenden Ansprüche, **dadurch gekennzeichnet, dass** das Bauteil (12) eine Schaufel eines Rotors einer Gasturbine ist.

10. Vorrichtung nach Anspruch 9, **dadurch gekennzeichnet, dass** die Schaufel Bestandteil einer integralen Rotor-Konstruktion (BLISK oder BLING) ist.

11. Verfahren zur partiellen Beschichtung von Bauteilen einer Gasturbine oder eines Flugtriebwerkes, wobei das Verfahren folgende Schritte umfasst:
a) Aufnahme und Positionieren des Bauteils (12) in einer Grundaufnahme (14);
b) Abdecken eines nicht zu beschichtenden Teilbereichs (20) des Bauteils (12) mittels einer Abdeckung (16), wobei ein zu beschichtender Teilbereich (22) des Bauteils (12) durch eine Ausnahme oder Öffnung (18) in der Abdeckung (16) hindurchgeführt wird;
c) Beschichten des zu beschichtenden Teilbereichs (22) des Bauteils (12), **dadurch gekennzeichnet, dass** die Form der Ausnahme oder Öffnung (18) dem Profil eines Schaufelblatts in dem Bereich zwischen dem nicht zu beschichtenden und dem zu beschichtenden Teilbereich (20, 22) entspricht.

12. Verfahren nach Anspruch 11, **dadurch gekennzeichnet, dass** vor dem Verfahrensschritt c) eine Fixierung der Grundaufnahme (14) mit der Abdeckung (16) mittels einer Fixiervorrichtung (28) erfolgt.

13. Verfahren nach Anspruch 12, **dadurch gekennzeichnet, dass** die Fixiervorrichtung (28) hülsenartig mit mindestens einer Durchtrittöffnung (30) zum Durchtritt des zu beschichtenden zweiten Teilbereichs (22) des Bauteils (12) ausgebildet ist.

14. Verfahren nach einem der Ansprüche 11 bis 13, **dadurch gekennzeichnet, dass** durch das Beschichten gemäß Verfahrensschritt c) eine Schutzschicht, insbesondere eine Erosionsschutzschicht ausgebildet wird.

15. Verfahren nach Anspruch 14, **dadurch gekennzeichnet, dass** die Schutzschicht aus einem hartkeramischen Werkstoff und/oder einem Metall oder einer Metall-Legierung besteht.

## Claims

1. A device for the partial coating of components of a gas turbine or of an aircraft engine, wherein the device (10) has at least one base receiver (14) for at least partly receiving the component (12) and a first partial region (20) of the component (12) that is not to be coated, and also has at least one plate-like cover (16) which can be positioned in the base receiver (14), wherein the cover (16) has at least one recess or opening (18) for the passage of a second partial region (22) of the component (12) that is to be coated, **characterised in that** the form of the recess or opening (18) corresponds to the profile of a blade leaf in the region between the partial region (20) that is not to be coated and the partial region (22) that is to be coated, in particular in consideration of a defined gap clearance for a homogeneous layer run-out.

2. A device according to claim 1, **characterised in that** the cover (16) is formed in one part or multiple parts, so as to be planar, non-planar or arched, or straight, curved or polygonal in cross-section.

3. A device according to claim 1 or 2, **characterised in that** the cover (16) consists of metal, a metal alloy, ceramic material, glass or plastics material, in particular temperature-resistant plastics material.

4. A device according to one of the preceding claims, **characterised in that** the base receiver (14) has for the purposes of positioning the cover (16), in particular positioning it vertically, corresponding supporting regions (24, 26) or projections.

5. A device according to one of the preceding claims, **characterised in that** the device (10) has at least one fixing device (28) for detachably fixing the cover (16) on the base body (12).

6. A device according to claim 5, **characterised in that** the fixing device (28) is formed so as to be sleeve-like with at least one passage opening (30) for the passage of the second partial region (22) of the component (12) that is to be coated.

7. A device according to one of the preceding claims, **characterised in that** the coating is a protective layer, in particular a layer protecting against erosion.

8. A device according to claim 7, **characterised in that** the protective layer consists of a hard-ceramic material and/or a metal or a metal alloy.

9. A device according to one of the preceding claims, **characterised in that** the component (12) is a blade of a rotor of a gas turbine.

10. A device according to claim 9, **characterised in that** the blade is part of an integral rotor construction (BLISK or BLING).

11. Method for partially coating components of a gas turbine or an aircraft engine, wherein the method comprises the following steps:
a) receiving and positioning the component (12) in a base receiver (14);
b) covering by means of a cover (16) a partial region (20) of the component (12) that is not to be coated, wherein a partial region (22) of the component (12) that is to be coated is guided through a recess or opening (18) in the cover (16);
c) coating the partial region (22) of the component (12) that is to be coated, **characterised in that** the form of the recess or opening (18) corresponds to the profile of a blade leaf in the region between the partial region (20) that is not to be coated and the partial region (22) that is to be coated.

12. Method according to claim 11, **characterised in that** prior to the method step c) the base receiver (14) with the cover (16) is fixed by means of a fixing device (28).

13. Method according to claim 12, **characterised in that** the fixing device (28) is formed in a sleeve-like manner with at least one passage opening (30) for the passage of the second partial region (22) of the component (12) that is to be coated.

14. Method according to one of claims 11 to 13, **characterised in that** as a result of the coating in accordance with method step c) a protective layer, in particular a layer protecting against erosion, is formed.

15. Method according to claim 14, **characterised in that** the protective layer consists of a hard-ceramic material and/or a metal or a metal alloy.

## Revendications

1. Dispositif pour le revêtement partiel de composants d'une turbine à gaz ou d'un moteur d'avion, ledit dispositif (10) comportant au moins un logement de base (14) pour la réception au moins partielle du composant (12) et d'une première zone partielle (20) du composant (12) n'ayant pas à être revêtue, ainsi qu'au moins un couvercle (16) en forme de plaque pouvant être mis en place dans le logement de base (14), ledit couvercle (16) comportant au moins un évidement ou une ouverture (18) pour le passage d'une deuxième zone partielle (22) du composant (12) ayant à être revêtue, **caractérisé en ce que** la forme de l'évidement ou de l'ouverture (18) correspond au profil d'une pale dans la zone entre la zone partielle n'ayant pas à être revêtue et celle ayant à être revêtue (20, 22), en particulier compte tenu d'une cote de jeu définie pour une sortie de couche homogène.

2. Dispositif selon la revendication 1, **caractérisé en ce que** le couvercle (16) est réalisé en une seule ou en plusieurs pièces, plan, non plan ou bombé, ou avec une section transversale droite, courbe ou polygonale.

3. Dispositif selon la revendication 1 ou la revendication 2, **caractérisé en ce que** le couvercle (16) est en métal, en alliage métallique, en céramique, verre ou matière synthétique, en particulier en matière synthétique résistante à la chaleur.

4. Dispositif selon l'une des revendications précédentes, **caractérisé en ce que** le logement de base (14) comporte des zones d'appui (24, 26) ou des saillies adaptées pour la mise en place, en particulier pour la mise en place en hauteur du couvercle (16).

5. Dispositif selon l'une des revendications précédentes, **caractérisé en ce que** ledit dispositif (10) comporte au moins un mécanisme de fixation (28) pour la fixation amovible du couvercle (16) sur le corps de base (12).

6. Dispositif selon la revendication 5, **caractérisé en ce que** le mécanisme de fixation (28) est réalisé en forme de douille avec au moins une ouverture de passage (30) permettant le passage de la deuxième zone partielle (22) du composant (12) à revêtir.

7. Dispositif selon l'une des revendications précédentes, **caractérisé en ce que** le revêtement consiste en une couche protectrice, en particulier une couche de protection contre l'érosion.

8. Dispositif selon la revendication 7, **caractérisé en ce que** la couche protectrice est en matériau céramique dur et/ou en métal ou en alliage métallique.

9. Dispositif selon l'une des revendications précédentes, **caractérisé en ce que** le composant (12) est une pale d'un rotor d'une turbine à gaz.

10. Dispositif selon la revendication 9, **caractérisé en ce que** la pale est un élément d'une construction de rotor intégrée (BLISK ou BLING).

11. Procédé de revêtement partiel de composants d'une turbine à gaz ou d'un moteur d'avion, ledit procédé comprenant les étapes suivantes :
a) logement et mise en place du composant (12) dans un logement de base (14) ;
b) couverture d'une zone partielle (20) du composant (12) n'ayant pas à être revêtue par un couvercle (16), une zone partielle (22) du composant (12) ayant à être revêtue étant passée par un évidement ou une ouverture (18) ménagés dans le couvercle (16) ;
c) revêtement de la zone partielle (22) du composant (12) à revêtir, **caractérisé en ce que** la forme de l'évidement ou de l'ouverture (18) correspond au profil d'une pale dans la zone entre la zone partielle n'ayant pas à être revêtue et celle ayant à être revêtue (20, 22).

12. Procédé selon la revendication 11, **caractérisé en ce qu'**une fixation du logement de base (14) avec le couvercle (16) au moyen d'un mécanisme de fixation (28) est effectuée avant l'étape de procédé c).

13. Procédé selon la revendication 12, **caractérisé en ce que** le mécanisme de fixation (28) est réalisé en forme de douille avec au moins une ouverture de passage (30) permettant le passage de la deuxième zone partielle (22) du composant (12) à revêtir.

14. Procédé selon l'une des revendications 11 à 13, **caractérisé en ce qu'**une couche protectrice, en particulier une couche de protection centre l'érosion est obtenue par le revêtement suivant l'étape de procédé c).

15. Procédé selon la revendication 14, **caractérisé en ce que** la couche protectrice est en matériau céramique dur et/ou en métal ou en alliage métallique.
